(19) Europäisches Patentamt
European Patent Office
Office européen des brevets

(11) Numéro de publication : **0 461 989 B1**

# (12) FASCICULE DE BREVET EUROPEEN

(45) Date de publication du fascicule du brevet : **15.09.93 Bulletin 93/37**

(51) Int. Cl.[5] : **H05K 7/20**

(21) Numéro de dépôt : **91401535.9**

(22) Date de dépôt : **11.06.91**

## (54) Dispositif utilisant des composants électroniques montés en surface et comprenant un dispositif de refroidissement perfectionné.

(30) Priorité : **12.06.90 FR 9007267**

(43) Date de publication de la demande : **18.12.91 Bulletin 91/51**

(45) Mention de la délivrance du brevet : **15.09.93 Bulletin 93/37**

(84) Etats contractants désignés : **AT BE CH DE DK ES FR GB IT LI LU NL SE**

(56) Documents cités :
**EP-A- 0 263 729**
**DE-A- 3 212 592**

(56) Documents cités :
**DE-A- 3 500 976**
**RESEARCH DISCLOSURE. no. 265, mai 86, HAVANT GB page 267 ref. No 26530: "flexible shell conduction/convection cooling device"**

(73) Titulaire : **TONNA ELECTRONIQUE**
**36, avenue Hoche B.P. 287**
**F-51060 Reims Cédex (FR)**

(72) Inventeur : **Bour, Gilles**
**4D rue de la Corchade**
**F-57070 Metz (FR)**

(74) Mandataire : **Martin, Jean-Jacques et al**
**Cabinet REGIMBEAU 26, Avenue Kléber**
**F-75116 Paris (FR)**

EP 0 461 989 B1

Il est rappelé que : Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

## Description

La présente invention concerne le domaine des systèmes électroniques utilisant des composants pour montage en surface.

Ces composants pour montage en surface sont généralement dénommés "CMS".

Les composants CMS comprennent des puces de semiconducteurs placées dans des boîtiers en matière plastique pourvus de pattes de raccordement, coplanaires, destinées à être soudées directement, en surface, sur les pistes conductrices d'un circuit imprimé.

L'invention concerne plus particulièrement la dissipation thermique au niveau des cartes électroniques et le refroidissement des composants actifs de type CMS.

Les composants de type CMS et les composants en boîtier à fils classiques utilisent souvent des puces identiques. La dissipation thermique d'un boîtier de type CMS est cependant dans certains cas trois fois inférieure à celle du boîtier classique pour un composant équivalent, ce qui limite fortement son utilisation, notamment pour les transistors haute fréquence de moyenne puissance.

L'invention a donc pour but de favoriser la dissipation thermique d'un composant de type CMS vers l'air ambiant sans dégrader ses performances électriques.

La figure 1 annexée rappelle les paramètres intervenant dans le calcul de l'élévation de température de la jonction d'un semiconducteur.

Rth j-c : résistance thermique jonction-boîtier.
Rth c-a : résistance thermique boîtier air ambiant.
Rth r : résistance thermique du radiateur.
Tj : température de la jonction.
Tc : température du boîtier.
Ta : température ambiante.
P : puissance dissipée dans la jonction.

La température de jonction est donnée par :

$$Tj = Ta + P \left( Rth\ j\text{-}c + \frac{Rth\ c\text{-}a\ .\ Rth\ r}{Rth\ c\text{-}a + Rth\ r} \right)$$

L'élévation de température d'un semiconducteur pour une puissance donnée, dépend donc de deux paramètres.

D'une part, la résistance thermique jonction-boîtier (Rth j-c) qui dépend essentiellement du type de boîtier utilisé et de la technologie de fabrication du composant. D'autre part, un terme $\frac{Rthc - a\ .\ Rthr}{Rthc - a + Rthr}$ caractérisant la capacité pour un composant électronique de dissiper la chaleur qu'il produit. Il apparaît que ce terme peut être fortement réduit en utilisant des radiateurs offrant une bonne dissipation thermique (Rthr faible).

Pour les composants électroniques classiques à fils en boîtier métallique, il existe de nombreux radiateurs de dimensions et de formes très diverses pouvant se fixer sur les boîtiers de ces composants et permettant ainsi de maîtriser parfaitement la dissipation thermique.

Pour les composants de type CMS, il n'en est pas de même car les boîtiers sont en matière plastique et interdisent donc toute fixation mécanique d'un radiateur. Les fabricants de composants recommandent donc de réaliser des plots de soudure de surface importante afin d'améliorer la dissipation thermique.

Un boîtier CMS associé de façon classique à un pavé de cuivre de surface importante est illustré schématiquement sur la figure 2 annexée.

Sur cette figure on a représenté schématiquement un boîtier 10 de transistor HF de type CMS comprenant une base 12, deux émetteurs 14, 16 et un collecteur 18.

La base 12, les émetteurs 14, 16 et le collecteur 18 sont soudés sur des pistes conductrices portées par un circuit imprimé 20. On aperçoit également sur la figure 2 annexée un pavé de cuivre 22 de surface importante lié à la patte de collecteur 18.

La disposition représentée sur la figure 2 associée est conforme aux recommandations données dans la note BFG 135 diffusée par la Société Philips pour un transistor large bande NPN 1GHz.

L'utilisation de "pavés" de cuivre au niveau des plots de soudure d'un composant augmente la capacité de ces plots et est donc préjudiciable pour l'utilisation des composants en haute fréquence. Elle conduit également à une augmentation de la surface nécessaire pour une réalisation et n'améliore pas la dissipation thermique vers l'air ambiant lorsque le dispositif électronique est logé dans un boîtier étanche.

Comme indiqué précédemment le but de l'invention est de proposer un nouveau dispositif permettant d'améliorer la dissipation thermique des composants de type "montage en surface" (CMS) sans en dégrader les performances.

A cette fin, la présente invention propose, dans un dispositif comprenant des composants électroniques montés en surface, de placer un élément, tel qu'un cylindre, en matériau diélectrique apte à assurer la fonction de shunt thermique entre une connexion d'un composant électronique de type CMS et un élément radiateur.

La disposition ainsi proposée dans le cadre de la présente invention permet de diminuer de manière significative la résistance thermique entre le boîtier d'un composant CMS et l'air ambiant et ce sans affecter les performances électriques du produit.

D'autres caractéristiques, buts et avantages de la présente invention apparaîtront à la lecture de la description détaillée qui va suivre et en regard des dessins annexés, donnés à titre d'exemples non limitatifs sur lesquels :

- la figure 1 précédemment évoquée rappelle les paramètres intervenant dans le calcul de l'élévation de température de la puce d'un semiconducteur,
- la figure 2 précédemment évoquée représente l'état de l'art en matière de refroidissement de composant CMS,
- la figure 3 représente la structure d'un dispositif de refroidissement conforme à une première variante de réalisation de la présente invention, et
- la figure 4 représente la structure d'un dispositif de refroidissement conforme à un autre mode de réalisation préférentiel de la présente invention.

Le dispositif refroidissement conforme à un mode de réalisation de l'invention, représenté figure 3, comprend principalement un élément 305 réalisé dans un matériau diélectrique de type alumine ou céramique présentant une faible conductivité électrique tout en ayant une conductivité thermique intéressante pour l'application.

Comme représenté sur la figure 3 l'élément 305 est de préférence un cylindre, très préférentiellement un cylindre de révolution.

La figure 3 représente un composant CMS 302 pouvant être un transistor de moyenne puissance HF monté sur un circuit imprimé 301. La connexion 303 du composant est soudée sur un "pavé" de cuivre 304 conformément aux recommandations du constructeur. Cependant, contrairement à l'état de l'art qui consiste à augmenter la surface du pavé 304 pour améliorer la dissipation thermique du composant, selon la présente invention, la base 3051 du cylindre 305 est appliquée sur un pavé 304 de surface réduite et un élément radiateur est appliqué sur le sommet 3052 du cylindre. Le cylindre 305 assure ainsi la fonction de shunt thermique entre le composant et un élément radiateur.

L'élément radiateur placé sur le sommet 3052 du cylindre peut être formé par tout radiateur connu ou dérivé de l'état de la technique. Pour cette raison le radiateur n'a pas été représenté sur la figure 3 annexée pour simplifier l'illustration.

Le radiateur est de préférence métallique.

Le radiateur peut par exemple être formé d'un boîtier étanche, notamment métallique, logeant le circuit électronique et venant en contact avec le sommet 3052 du cylindre 305.

L'invention permet donc :

- de limiter la surface nécessaire à la réalisation d'une carte électronique,
- de ne pas affecter les caractéristiques électriques du composant et ce notamment en haute fréquence,
- d'assurer la dissipation thermique vers l'extérieur d'un dispositif électronique contenu dans un boîtier étanche en utilisant ce même boîtier comme radiateur entrant en contact au niveau de la face 3052 du cylindre 305.

La figure 4 représente un mode de réalisation préférentiel du dispositif de refroidissement conforme à la présente invention.

Le cylindre 405 en matériau diélectrique, représenté sur la figure 4, présente dans ce mode de réalisation, une métallisation 406 sur sa base.

Cette métallisation permet de souder le cylindre 405 sur le circuit imprimé tout comme un autre composant.

La forme et les dimensions du cylindre sont déterminées d'une part pour assurer la fonction de shunt thermique et d'autre part, dans la mesure du possible, pour être manipulable par un robot automatique de câblage.

La présente invention trouve en particulier application à la réalisation d'un dispositif de dissipation thermique dans le cas des cartes électroniques montées dans un boîtier métallique étanche afin d'assurer une bonne immunité radioélectrique en haute fréquence.

## Revendications

1. Dispositif comprenant des composants électroniques montés en surface, caractérisé par le fait qu'il comprend un élément (305, 405) en matériau diélectrique placé entre une connexion (303) d'un composant monté en surface (302) et un élément radiateur, pour assurer la fonction de shunt thermique entre ceux-ci.

2. Dispositif selon la revendication 1, caractérisé par le fait que l'élément (305, 405) en matériau diélectrique à la forme d'un cylindre.

3. Dispositif selon l'une des revendications 1 ou 2, caractérisé par le fait que l'élément (305, 405) en matériau diélectrique a la forme d'un cylindre de révolution.

4. Dispositif selon l'une des revendications 1 à 3, caractérisé par le fait que le matériau diélectrique est de l'alumine.

5. Dispositif selon l'une des revendications 1 à 3, caractérisé par le fait que le matériau diélectrique est de la céramique.

6. Dispositif selon l'une des revendications 1 à 5, caractérisé par le fait que l'élément radiateur en contact avec une face (3052) de l'élément (305, 405) en matériau diélectrique, est métallique.

7. Dispositif selon l'une des revendications 1 à 6, caractérisé par le fait que l'élément radiateur est constitué par le boîtier contenant le dispositif électronique.

8. Dispositif selon l'une des revendications 1 à 7, caractérisé par le fait que l'élément (305, 405) en matériau diélectrique comporte une métallisation (406) à sa base permettant de le souder sur une carte de circuit imprimé (301) au même titre qu'un composant électronique.

9. Dispositif de refroidissement formé d'un élément en matériau diélectrique tel que défini dans l'une des revendications 1 à 8.

10. Application du dispositif de refroidissement conforme à l'une des revendications 1 à 9 à la réalisation d'un équipement électronique dans un boîtier métallique blindé.

## Patentansprüche

1. Vorrichtung, die oberflächenmontierte elektronische Bauteile umfaßt,
dadurch **gekennzeichnet**,
daß sie ein Element (305, 405) aus dielektrischem Material enthält, angeordnet zwischen einer Verbindungsstelle (303) eines oberflächenmontierten Bauteils (302) und einem Abstrahlelement, um zwischen diesen die Funktion eines Wärmeshunts zu gewährleisten.

2. Vorrichtung nach Anspruch 1, dadurch gekennzeichnet, daß das Element (305, 405) aus dielektrischem Material die Form eines Zylinders aufweist.

3. Vorrichtung nach einem der Ansprüche 1 oder 2, dadurch gekennzeichnet, daß das Element (305, 405) aus dielektrischem Material die Form eines Rotationszylinders aufweist.

4. Vorrichtung nach einem der Ansprüche 1 bis 3, dadurch gekennzeichnet, daß das dielektrische Material Aluminiumoxid ist.

5. Vorrichtung nach einem der Ansprüche 1 bis 3, dadurch gekennzeichnet, daß das dielektrische Material Keramik ist.

6. Vorrichtung nach einem der Ansprüche 1 bis 5, dadurch gekennzeichnet, daß das Abstrahlelement, in Kontakt mit einer Fläche (3052) des Elements (305, 405) aus dielektrischem Material, metallisch ist.

7. Vorrichtung nach einem der Ansprüche 1 bis 6, dadurch gekennzeichnet, daß das Abstrahlelement gebildet wird durch das Gehäuse, das die elektronische Vorrichtung enthält.

8. Vorrichtung nach einem der Ansprüche 1 bis 7, dadurch gekennzeichnet, daß das Element (305, 405) aus dielektrischem Material an seiner Basis eine Metallisierung (406) aufweist, die ermöglicht, es auf die Platine einer gedruckten Schaltung zu löten, genauso wie ein elektronisches Bauteil.

9. Kühlvorrichtung, gebildet aus einem Element aus dielektrischem Material, wie definiert in einem der Ansprüche 1 bis 8.

10. Anwendung der Kühlvorrichtung nach einem der Ansprüche 1 bis 9 für die Herstellung eines elektronischen Ausrüstungsteils in einem abgeschirmten metallischen Gehäuse.

## Claims

1. Device comprising surface-mounted electronic components, characterised by the fact that it comprises an element (305, 405) made from dielectric material placed between a connection (303) on a surface-mounted component (302) and a heat sink, in order to fulfil the function of a thermal shunt between them.

2. Device according to Claim 1, characterised by the fact that the element (305, 405) made from dielectric material is in the shape of a cylinder.

3. Device according to one of Claims 1 or 2, characterised by the fact that the element (305, 405) made from dielectric material is in the shape of a cylinder formed by rotation.

4. Device according to one of Claims 1 to 3, characterised by the fact that the dielectric material is alumina.

5. Device according to one of Claims 1 to 3, characterised by the fact that the dielectric material is ceramic.

6. Device according to one of Claims 1 to 5, characterised by the fact that the heat sink in contact with one face (3052) of the element (305, 405) made from dielectric material is metallic.

7. Device according to one of Claims 1 to 6, characterised by the fact that the heat sink is formed by the case containing the electronic device.

8. Device according to one of Claims 1 to 7, characterised by the fact that the element (305, 405) made from dielectric material has metallisation (406) on its base making it possible to solder it to a printed circuit board (301) in the same way as an electronic component.

9. Cooling device formed by an element made from dielectric material as defined in one of Claims 1 to 8.

10. Application of the cooling device according to one of Claims 1 to 9 to the production of electronic equipment in an armoured metal case.

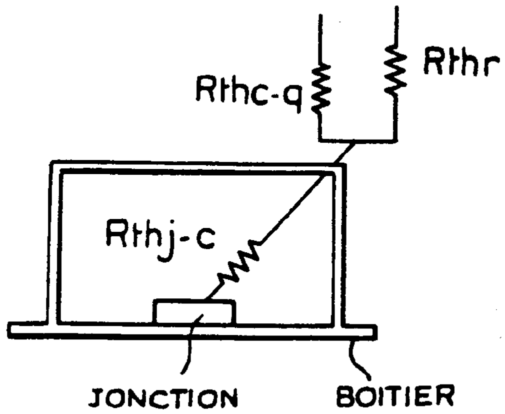


FIG.1 Etat de la Technique

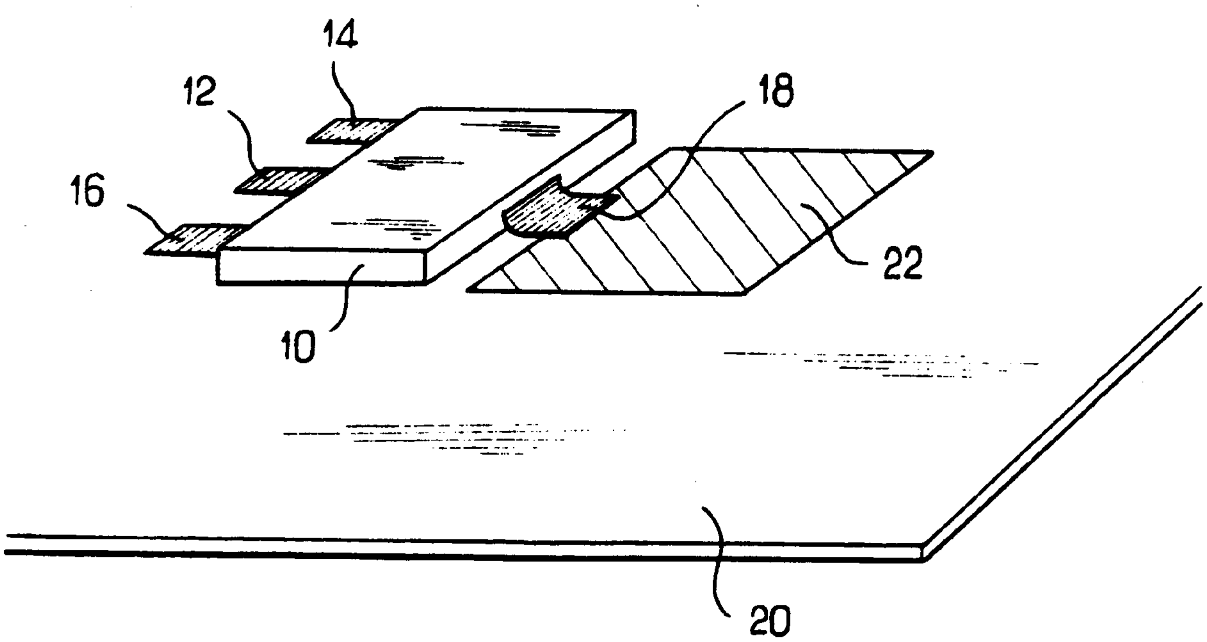


FIG.2 Etat de la Technique

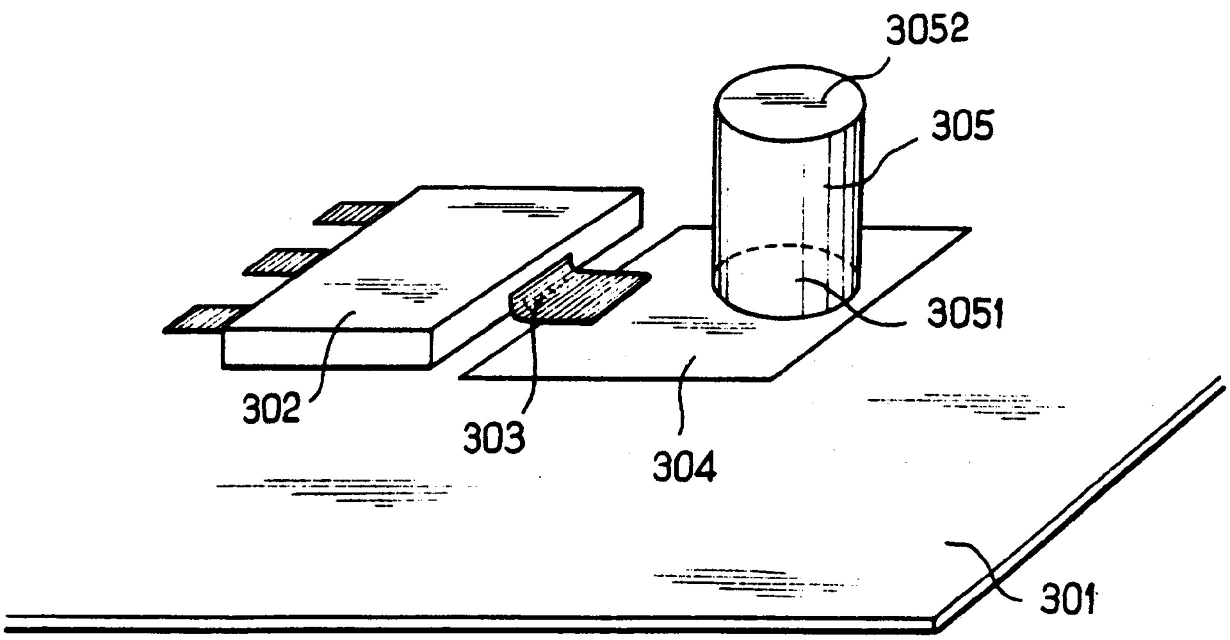


FIG_3

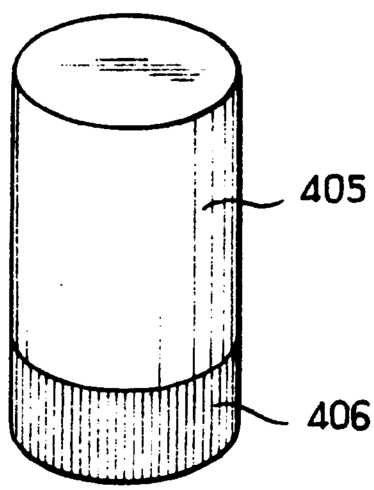


FIG_4